# EUROPEAN PATENT SPECIFICATION

(11) **EP 0 711 039 B1**
(45) Date of publication and mention of the grant of the patent: **24.05.2000**
(21) Application number: 95307711.2
(22) Date of filing: 30.10.1995
(51) Int. Cl.: H03K 17/00, G06G 7/06, G06J 1/00, G06G 7/12, H03K 19/08, H03K 19/177, G11C 27/04, H03M 1/12, H03M 1/66

(54) **General purpose charge mode analog operation circuit**
Mehrzweck-Analogverarbeitungsschaltung aus ladungsgekoppelten Elementen
Circuit d'opérations analogiques à transfert de charge et d'application générale

(30) Priority: 31.10.1994 JP 29053794
(43) Date of publication of application: 08.05.1996
(73) Proprietor: G.D.S. CO., LTD., Minato-ku, Tokyo (JP); Nagazumi, Yasuo, Tokyo (JP)
(72) Inventor: Nagazumi, Yasuo, Meguro-ku, Tokyo 153 (JP)
(74) Representative: Gordon, Richard John Albert

(56) References cited:
- US-A- 4 464 726
- SOLID STATE IMAGING ARRAYS, SAN DIEGO, CA, USA, 22-23 AUG. 1985, vol. 570, ISSN 0277-786X, PROCEEDINGS OF THE SPIE - THE INTERNATIONAL SOCIETY FOR OPTICAL ENGINEERING, 1985, USA, pages 191-197, XP000677138 LAMB D R ET AL: "Analog array processing of PtSi focal plane imagery"
- PATENT ABSTRACTS OF JAPAN vol. 017, no. 532 (P-1619), 24 September 1993 & JP 05 143567 A (G D S:KK;OTHERS: 01), 11 June 1993,

## Description

The present invention relates to a general purpose charge mode analog operation circuit for attaining, on the same hardware, an adder, multiplier, divider (A/D converter) and other functions according to the difference of their operation status.

Recent developments in digital technology have achieved massive and systematic generation of microscopic structures of extremely simple elements based on cascadic signal processing modes unified by a simple standard referred to as binary logic.

On the other hand, miniaturisation and pursuit of higher speed of digital circuits through the development of processing technology tends to increase power consumption giving rise to more serious problems of supplying more power and handling greater heat dissipation.

Analog technology however utilises the interaction of devices so that standardisation is difficult and developments with respect of miniaturisation or introduction of higher functions is extremely slow compared with digital technology.

However, systems involved with physical phenomena must always have some portion for handling analog signals and in many cases, depending on the objective, it is more efficient in terms of cost, power consumption and accuracy to process directly an analog signal, rather than use digital technology. However process is needed towards standardised processing in analog circuits in the future to conquer current problems such as variations in accuracy, drift and circuit size.

Charge transfer devices are particularly advantageous because of their ability to handle a sampled analog signal so as to enable information processing, essentially of the cascade type, and because of other properties making it ideal for analog circuit standardisation along with extremely low power consumption.

It has been proposed to use CCDs, which are one kind of charge transfer device, as multi-value memory and to arrange them in arrays for use in a digital processing systems (see J. HAN; PROGRESS IN COMPUTER-AIDED VLSI DESIGN; VOL.3; IMPLEMENTATIONS; pp. 67-118; ABLEX PUBLISHING, 1989 or H.G. KERKHOFF et al; IEEE trans. on Computers, C-30, No.9; 1981; PP. 644-652). However, the advantage of charge transfer devices has not been perceived for analog signal processing, because of their complex configuration and the many restrictions which are imposed and, in consequence, CCDs have not been widely used in this field.

In each of US-A-4,464,726 and US-A-5,089,983 there is disclosed a multiplier using a CCD wherein multiplication type D/A conversion is performed by adding signals in the charge domain.

In each of Japanese Patent Application Nos 5 154 513, 5 154 514, 5 312 640, 6 200 255 and Japanese unexamined patent publication No 6 237 173 there is disclosed multiplication type converters and A/D converters which utilise charge transfer devices.

The following should also be referred to: SOLID STATE IMAGING ARRAYS, San Diego, CA, USA, 22-23 aug. 1985, PROC.SPIE. D.R. LAMB ET AL. Analog array processing of PtSi focal plane imagery.

All of these proposals have a specialised configuration for achieving a single function but do not have the flexibility for allowing a multiplier to be used as an adder.

An object of the present invention is to provide a general purpose charge mode analog operation circuit comprising a standardised circuit structure allowing the circuit to perform more complex and flexible general functions than hitherto by effective use of charge transfer devices.

This is different from the basic concept of a conventional operations unit wherein operations are performed by transferring data to a specialised operation function section. The invention permits a desired operations function to be performed where the data is present (operations functions move while data is immobile) and thus reduce the time necessary for transfer in operations whose processing is performed depending on local data so as to obtain a general purpose charge mode analog operation circuit for allowing these operations to be performed more effectively.

According to the present invention there is provided a general purpose charge mode analog operation circuit comprising a two-dimensional lattice form circuit including charge transfer devices characterised in that a potential of all or part of charge transfer electrodes for driving said charge transfer devices is controlled independently, in that addition, multiplication, division, delay, sign inversion and other arithmetic operation functions are performed by cooperative control of the plurality of adjacent charge transfer devices in said two-dimensional lattice form circuit in that at least one analog charge signal is input on said two dimensional lattice form circuit prior to a beginning of each arithmetic operation function, and in that a driving control circuit is provided for supplying a plurality of charge transfer control signals defining a control mode of said two-dimensional lattice form circuit to the charge transfer electrodes in said two dimensional lattice form circuit whereby said plurality of charge transfer devices are controlled to selectively perform one of the arithmetic operation functions depending on the control mode.

Following is a description, by way of example only and with reference to the accompanying drawings, of one method of carrying the invention into effect.

In the drawings:-

Figure 1 is a circuit diagram illustrating a simple CCD operations device according to an embodiment of the invention.

Figure 2 is a circuit diagram of a CCD operations device showing a relatively complex lattice according to another embodiment of the invention.

Figure 3 is a circuit diagram of an embodiment wherein a conventional two-quadrant D/A converter is implemented in a lattice circuit for various converters of the invention.

Figure 4 is a circuit diagram of an embodiment wherein a two-quadrant D/A converter comprising a unit for equally division is implemented in parallel on the lattice of Figure 2.

Figure 5 is a circuit diagram of an embodiment including a four-quadrant D/A converter of the kind disclosed in Japanese Patent Application No 6 200 255.

Figure 6 is a circuit diagram of an embodiment of floating decimal point division type A/D converter of the invention.

Figure 7A is a circuit diagram of an embodiment of a 4x4 block adder for 16 pairs of differential signals.

Figure 7B is a circuit diagram of another embodiment of 4x4 block adder.

Figure 8 is a circuit diagram of an embodiment of circuit for equally dividing a charge packet into 4, 8 or 64 parts.

Figure 9 is a circuit diagram of an embodiment of a simple data transfer register of the invention acting also as delay circuit.

Figure 10 is a circuit diagram of an embodiment for exchanging the arrangement of two charge signals of the invention.

Figure 11 is a circuit diagram of an embodiment including a spatial data rearrangement mechanism of the kind disclosed in Japanese Patent Application No 5 143 567.

Figure 12A is a diagram showing the connection network N between CCD lattice circuits and control circuits according to the invention.

Figure 12B is a diagram showing the connection network N between main control circuit D and distributed control circuit D' which controls CCD lattice circuits according to the invention.

Figure 12C is a diagram showing programmable connection network S with connection program memory means R according to the invention.

Figure 12D is a diagram showing programmable connection network S controlled by a signal from outside of the chip in accordance with the invention.

Figure 13 is a circuit diagram showing a multiplier of a structure for performing multiplication type D/A conversion by providing a charge input gate of the number corresponding to the conventional bit number and by adding in charge domain according to the invention, and

Figure 14 is a circuit diagram showing a multiplication type D/A converter for directly dividing conventional charge input and selectively accumulating charges according to digital signal bit in accordance with the invention.

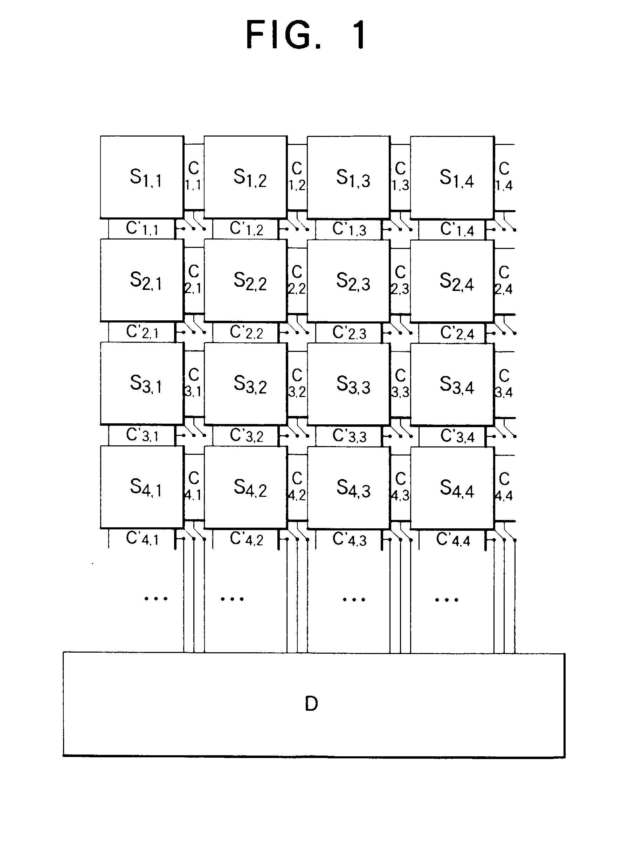

Referring now to the drawings, Figure 1 illustrates an embodiment of the simplest CCD operation unit of the invention. In this figure, a storage gate Sij is arranged at the lattice point of a square lattice and control gates Cij, C'ij connect adjacent storage gates along the lattice. Here, both storage and control gates are provided with a function of defining potential wells in the underlying semi-conductor substrate according to the applied potential and the control gate connects or disconnects potential wells of two adjacent storage gates.

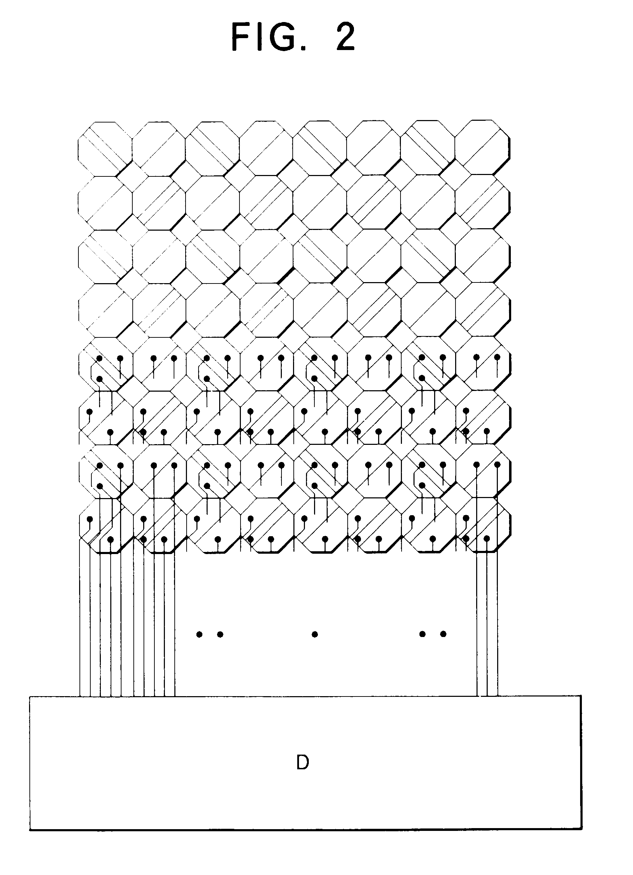

Figure 2 illustrates an embodiment of a CCD operation unit having a relatively complex lattice, wherein the lattice structure is basically composed of storage gates including a small number of control gates arranged among them. In this embodiment, all these gates are connected to a driving control circuit D through independent input terminals and all the desired functions are selected by the operation mode of circuit D. To make the illustration simple, only portions of the connections are shown.

The operation unit of Figure 1 and Figure 2 may be used for performing the following various operations according to its control mode.
(1) D/A conversion, two-quadrant multiplication, four quadrant multiplication
(2) A/D conversion, floating point division
(3) Block addition
(4) 2^{N} equal divider
(5) Inverter
(6) Data transfer line, delay line
(7) Spatial data parallel rearrangement

Now, specific examples of implementation of analog operation units of various functions will be described.

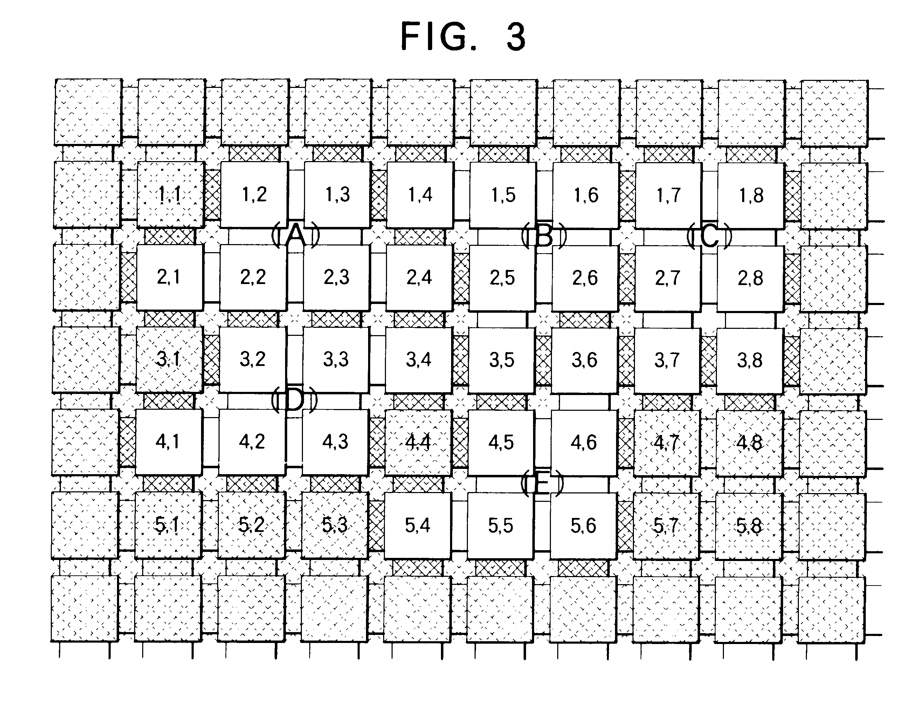

Figure 3 illustrates various converters arranged by implementing in the lattice circuit a two-quadrant D/A converter. In the figure, hatched areas indicate inactive gates where the formation of potential well is always inhibited and sections surrounded in the hatched areas correspond to areas for executing various operations.

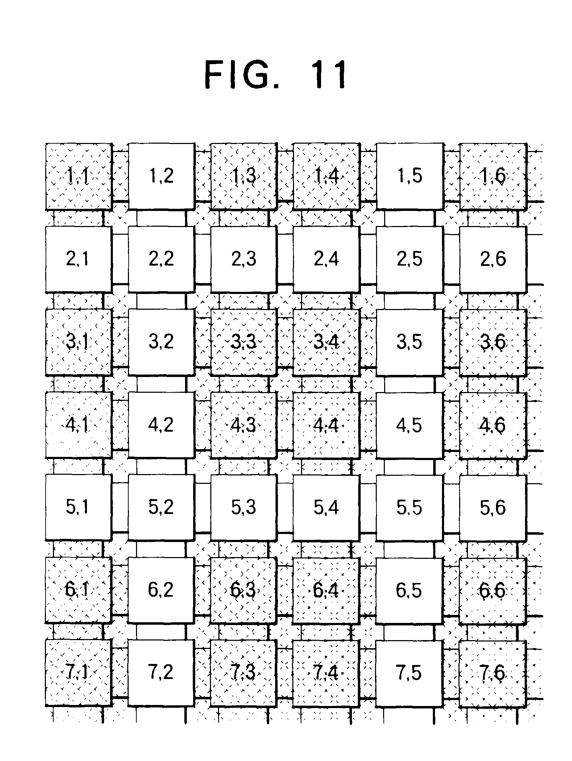

The same representation method shall be applied to respective examples shown in the following figures up to Figure 11.

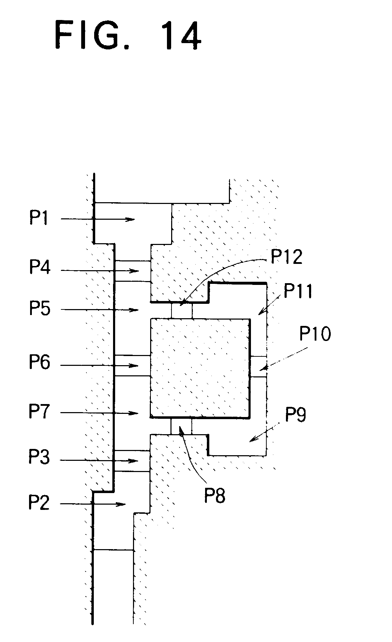

In the figures, (A), (B) and (C) are converters which are topologically equal to the converter shown in Figure 14 and (D) and (E) are converters of a type slightly modified from the same.

The functions of this unit shall not be explained herein, because it is described in detail in Japanese Patent Application Nos 5 154 514 and 6 200 255 and Japanese unexamined patent publication No 6 237 173.

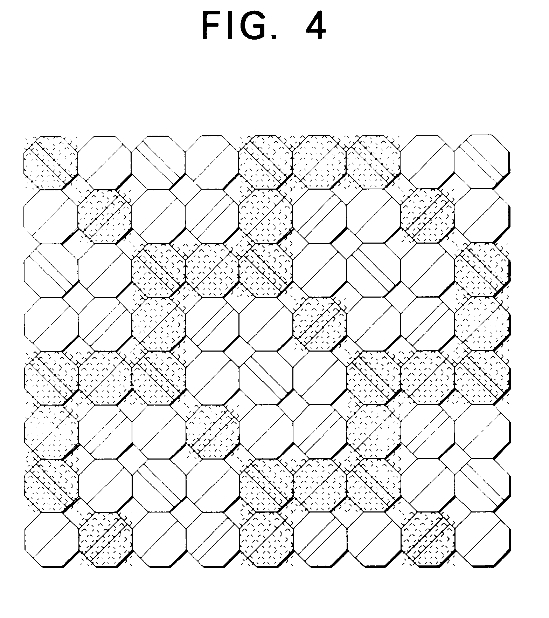

Figure 4 is a circuit diagram of an embodiment of a two-quadrant D/A converter comprising a unit for equal division.

However, as its function is similar to Figure 3, a detailed explanation is omitted.

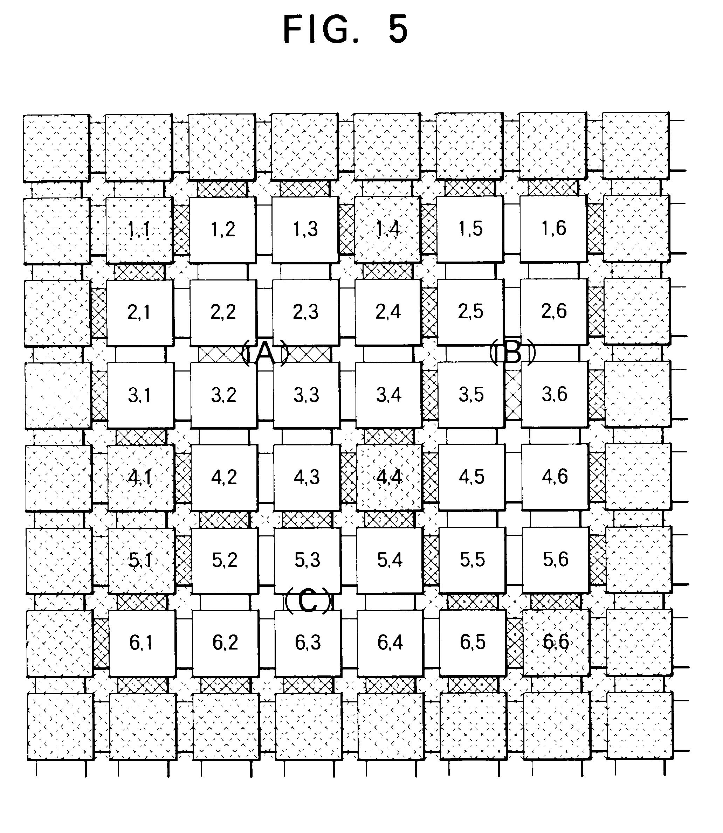

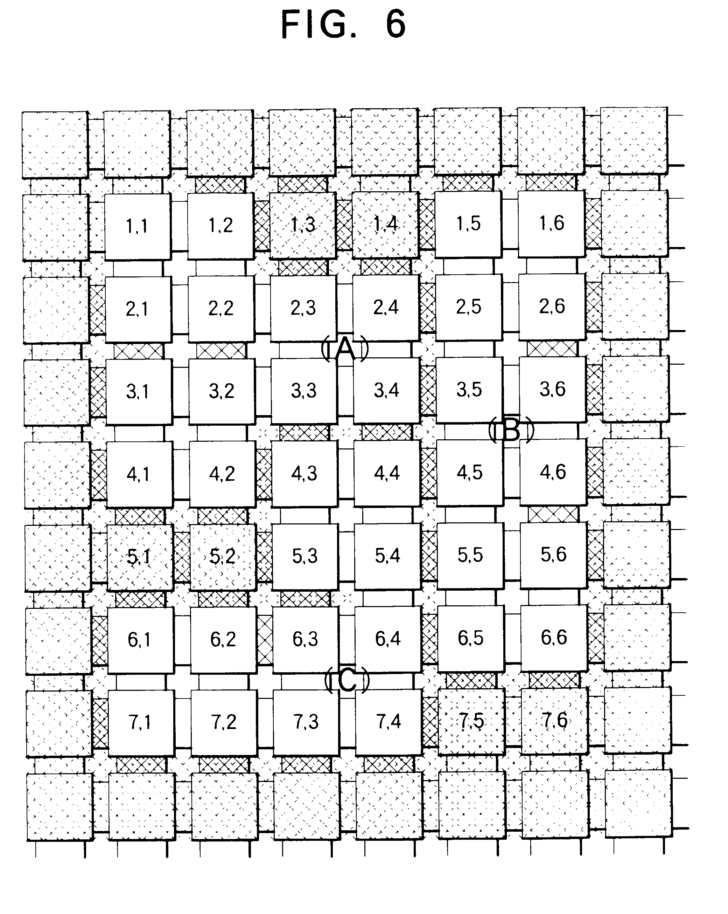

In the same way, Figure 5 is a circuit diagram of an embodiment of a four-quadrant D/A converter based on the disclosure in Japanese Patent Application No 6 200 255. Among the three types of converters shown in the figure, (A) and (B) comprise the four-quadrant D/A converter shown in Japanese Patent Application No 6 200 255 and Japanese unexamined patent application No 6 237 173 by combining the two converters (A) and (C) shown in Figure 3, while (C) is an embodiment of direct implementation of the composition shown in Figure 6 of Japanese Patent Application No 6 200 255.

Figure 6 shows an embodiment of implementation of floating point division type A/D converter. The essential function of this embodiment is similar to that shown in Japanese Patent Application No 5 154 513. However, a reiterative divider is installed also for the input signal, and 1/2 operation is added both to the input signal and the reference signal immediately after the beginning of the conversion and a function for forming the exponent portion has been added.

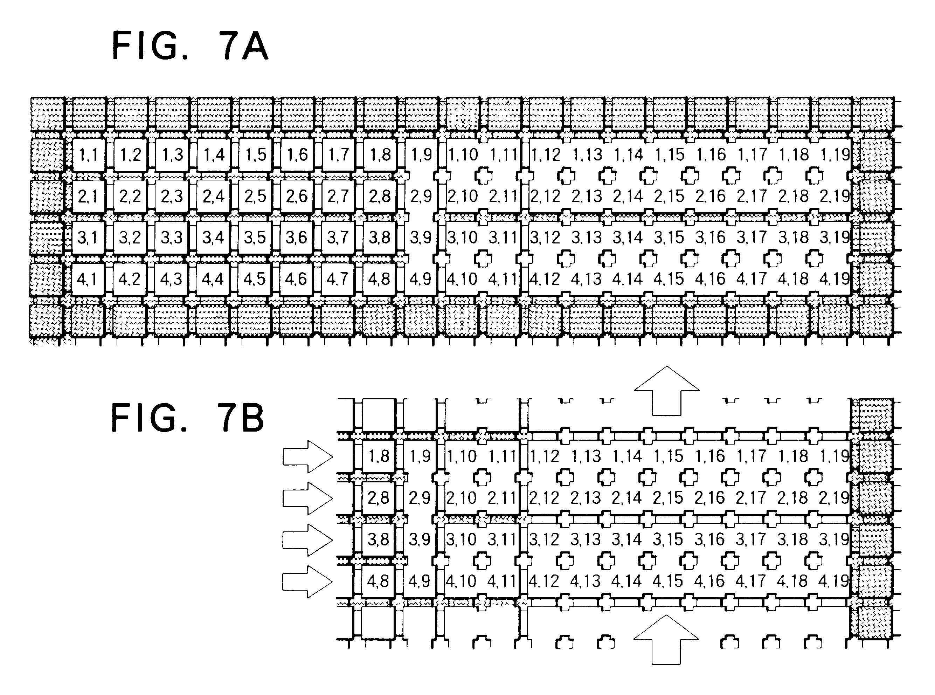

Both Figure 7A and 7B show an embodiment of implementation of 4 x 4 block adder for the differential signal.

In Figure 7A, the leftmost 32 gates maintain 16 differential input signals in the initial state, and allocate the positive and negative components of the differential signal to S_{i,2j-1} and S_{i,2j}, respectively, where i=1,2,....,4 and j=1,2,....4.

Moreover, two fused potential wells shown at the right end of Figure 7A define output buffers for accumulating positive and negative components respectively. A total of 32 input signal packets are added 4 by 4 in fused addition gates (S1,9;S2,9;S3,9;S4,9) by the shift operation toward the right. This charge signal is transferred alternatively to one of the two fused gates (S1,10;LS1,11;S2,10;S2,11) or (S3,10;S3,11;S4,10;S4,11) and is accumulated in two output buffers. As a consequence, 16 sets of differential signals are added for each component and output in the two buffers.

The composition of Figure 7B allows it to perform pipeline operation by replacing the input/output portion of Figure 7A with a shift register.

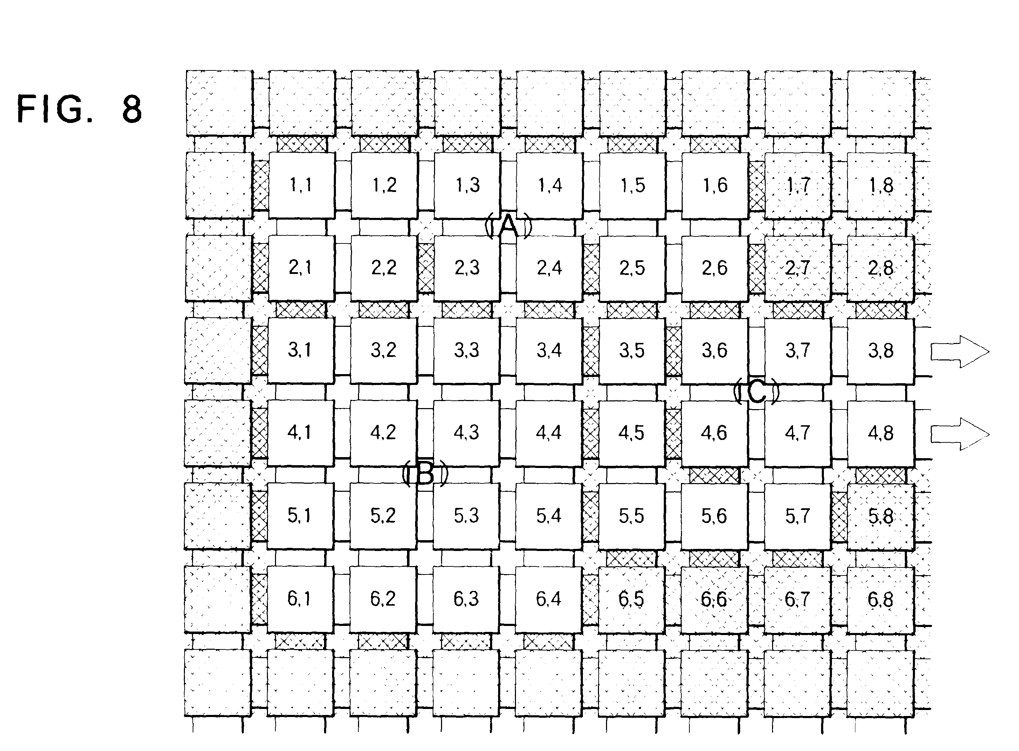

Figure 8 shows an embodiment of implementation of the circuit for equally dividing a charge packet into 4, 8 or 64 parts.

(A) in Figure 8 illustrates a parallel type unit for division into four equal parts.

Three units for dividing into two equal parts composed respectively by four storage gates S11, S12, S21, S22; S13, S14, S23, S24; S15, S16, S25, S26 are linked together through a tree structure and an input charge introduced into S13+S14 is divided by the middle unit for division into two equal parts and its output is again divided by the right and left units for dividing into two equal parts and is finally divided into four equal parts and output to respective gates S11, S12, S15 and S16.

As the equal division unit of this method requires (2^{N} -1)x4 storage gates for 2^{N} equal division, a large circuit area would be necessary for larger N, but as it is executed through pipeline type processing, the equal division unit has really the highest processing rate.

Figure 8 (B) represents a unit for dividing into eight equal parts of a semi parallel type. This example is obtained by sequentially performing three types of division operation into two equal parts.

First, four storage gates of respective S31, S32, S41, S42; S33, S34, S43, S44; S51, S52, S61, S62; S53, S54, S63, S64 begin the operation in a mode for defining continuously four large potential wells respectively. When the division into two equal parts is completed in this mode, the division result shall be arranged in two large potential wells of, for instance, S31, S32, S41; S42; S51, S52, S61, S62.

Next, the operation of C'41-44, it is separated into two upper and lower units for division into two equal parts providing half the capacity of the initial one.

The one is composed of four potential wells coupled two by two, S31, S32; S41, S42; S33, S34; S43, S44 and the other is composed of S51, S52; S61, S62; S53, S54; S63, S34 respectively, and two storage gates are coupled to define a potential well.

Finally, the charge signals divided into four equal parts by this division are divided respectively into two equal parts by four units for division into two equal parts composed of S31, S32, S41, S42; S33, S34, S43, S44; S51, S52, S61, S62; S53, S54, S63, S64 and finally are divided into a total eight parts.

This method requires a circuit size of about half the parallel method because it uses 2^{N+1} storage gates for division into 2^{N} equal parts, but the charge density variation at each gate of signal charge is substantially kept constant because the effective gate capacity of the divisions is reduced with a count of the division trials.

But, the processing rate is slower than the parallel type because pipeline processing is not used.

C in Figure 8 shows a serial type unit for dividing into 64 equal parts.

In this system, a unit for dividing into two equal parts composed of eight gates, S36, S37, S46, S47, C36, C46, C'36, C'37 is connected to an analog data stack composed of ten gates, S57, S56, S55, S45, S35, C56, C55, C'47, C'45, C'35 and the charge signal applied initially to S37, S47 pushes half charge signal of the result from divisions sequentially into the stack unto the result from division into two equal parts attains 1/64, then when it attains 1/64, two packets, as a result of division, are discharged outside in the direction of the arrows and the operation of returning the lst data issued from the stack to the unit for dividing into two equal parts is reiterated to perform the division into 64 equal parts.

This method advantageously allows modification of the function from division into 4 equal parts to division into 64 equal parts through the operation procedure but, disadvantageously, a low speed due to serial operation and an irregular output timing interval.

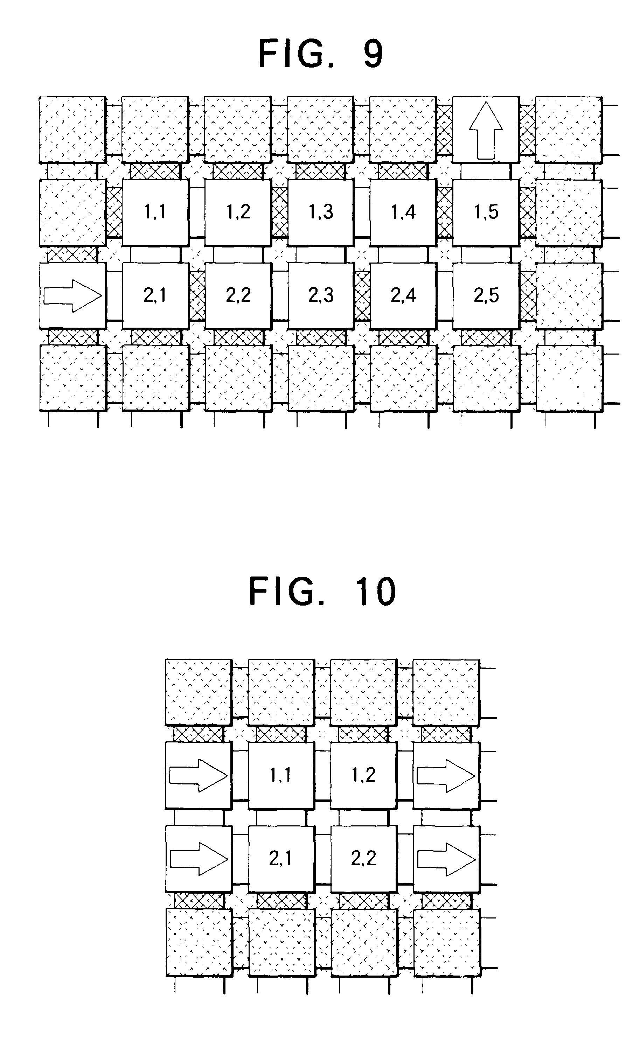

Figure 9 is a circuit diagram of an embodiment of a simple shift register for data transfer which also acts as a delay circuit.

Clearly, it can also be used as analog data stack as in the circuit (C) shown in Figure 8 by driving the shift register in an opposite direction.

Figure 10 is a circuit diagram of an embodiment for exchanging the arrangement of two charge signals which also acts as an inverter for reversing the sign if the two charge signals are differential types and, moreover, it also serves as basic logic element for calculating outputs from FUZZY AND or FUZZY OR gates, if two signals are one element of fuzzy variables and one element of membership functions. [See US-A-5,247,472 "Fuzzy logic operation circuit utilizing charge coupled devices" and Japanese examined patent publication No 532792 "Fuzzy operation circuit and fuzzy computer using the same".]

Figure 11 is a circuit diagram of an embodiment of spatial data rearrangement mechanism based on the disclosure in Japanese unexamined patent publication No 5 143 567.

In this embodiment, each of control gates C, C' acts depending on either of adjacent storage gates to perform a rapid data transfer as three phase CCD as the whole and also permits transfer of the signal in the opposite direction only by just changing the transfer clock phase.

Further, since the circuit according to the present invention has a homogeneous structure, respective functions as described above can be performed in arbitrary locations on this circuit through control of charge transfer electrodes constituting the circuit. Hence, output charge signals as a result of having performed certain operation functions can be used in the same locations as inputs of next different operation functions as they are.

For example, if the D/A conversion of Fig.3 (A) is performed as the Nth operation, 2 pieces of differential charge output signals of the result are output to S2,1 and S2,4. Subsequently, when the delay operation of Fig.9 is performed as N+1th operation, 2 pieces of the signals can be given a time difference (delay) of 7 pieces in the number of electrodes.

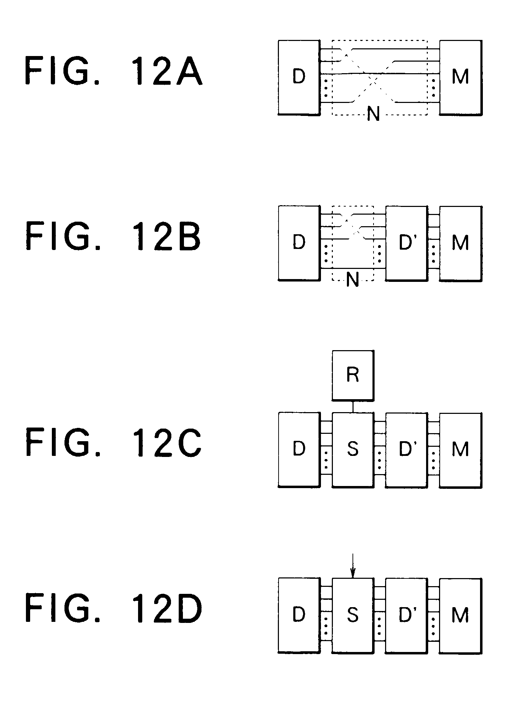

Figures 12A, 12B, 12C, 12D are circuit diagrams showing the relation between CCD lattice circuits M and control circuit D. On a lattice circuit utilising CCD, as mentioned above, various functions may be obtained, but these functions are defined mainly by control signals for driving CCD.

Therefore, the utilisation of user programmable type logic circuit like gate-array for said definition of functions enables the device to be incorporated into many kinds of applications.

Figure 12A is a diagram showing an arrangement for setting the connection N between control signal source and respective gate by using only a metal wiring process of the IC manufacturing processes during user programming and is the method commonly used for gate arrays and others.

In general, when the number of gates increases, such a composition is required wherein the control circuit is divided into circuit group D' and distributed over the lattice circuit for reducing the amount of wiring, as shown in Figure 12B.

Figure 12C is a diagram showing programming the connection between a control circuit and respective gates using a switch mechanism provided with a memory device R including EPROM in place of the connection N.

Figure 12D is a diagram showing the connection between a control circuit and respective gates using a switch mechanism S which can be electrically controlled from outside. In this embodiment, the function of whole the circuit may be set arbitrarily by an external signal (as indicated by the arrow).

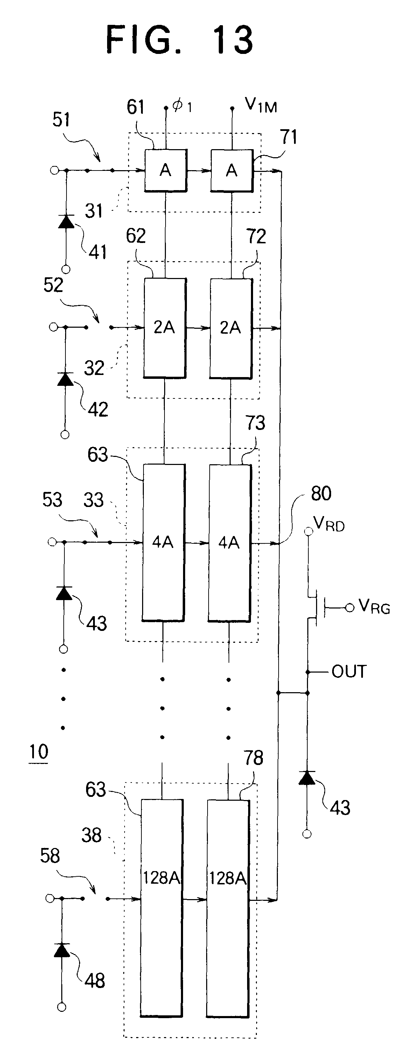

Figure 13 is a circuit diagram of a multiplier of a type disclosed in US-A-4,464,726 (Chiang) or US-A-5,089,983 (Chiang).

It will be apparent that the invention may be applied to analog processing, A/D conversion, D/A conversion or parallel processing for constructing general purpose analog signal processors which may perform various analog operational functions on a standardised CCD gate array allowing them, thereby, to provide already popular user programmable devices in the digital technology field and also to be effectively utilised in image data processing because it may perform an operation wherein operational functions are shifted without moving data and thereby improve the efficiency of massive parallel type operational processing.

## Claims

1. A general purpose charge mode analog operation circuit comprising a two-dimensional lattice form circuit including charge transfer devices (S_{1.1},...,C_{1.1},...,C'_{1.1},...) characterised in that a potential of all or part of charge transfer electrodes (S_{1.1},...,C_{1.1},...,C'_{1.1},...) for driving said charge transfer devices is controlled independently, in that addition, multiplication, division, delay, sign inversion and other arithmetic operation functions are performed by cooperative control of a plurality of adjacent charge transfer devices ((A)...) in said two-dimensional lattice form circuit, in that at least one analog charge signal is input on said two dimensional lattice form circuit prior to a beginning of each arithmetic operation function, and in that a driving control circuit (D) is provided for supplying a plurality of charge transfer control signals defining a control mode of said two-dimensional lattice form circuit to the charge transfer electrodes in said two dimensional lattice form circuit whereby said plurality of charge transfer devices are controlled to selectively perform one of the arithmetic operation functions depending on the control mode.

2. A circuit as claimed in Claim 1 characterised in that there is provided a two-dimensional lattice form circuit using a square lattice, said circuit being composed of a plurality of storage gates (S_{1.1},...) each of which is a charge transfer device arranged at each lattice point of the square lattice and a plurality of charge transfer devices (C_{1.1}...,C'_{1.1}...) each of which connects with two adjacent storage gates along the lattice.

3. A circuit as claimed in Claim 1 or Claim 2 characterised in that the driving control circuit (D) is distributed on a location in an exterior or interior of said lattice form circuit.

4. A circuit as claimed in any one of the preceding claims characterised in that said general purpose charge mode analog operation circuit modifies an operation function and its allocation on said lattice form circuit according to the control mode, at least within a certain area on the said lattice form circuit.

5. A circuit as claimed in any one of the preceding claims characterised in that there is provided a means for measuring the level of charge signal held with respect to at least a portion of the charge transfer devices.

6. A circuit as claimed in any one of the preceding claims characterised in that there is provided a sample and hold circuit for storing the measuring result of the measurement means as a voltage signal and a comparator means for comparing the magnitude of said voltage signal.

7. A circuit as claimed in Claim 6 characterised in that there is provided on the same chip a digital signal processing circuit for performing digital operation functions using output signals of the comparator means as a part of input.

8. A circuit as claimed in any one of the preceding claims characterised in that charge transfer devices arranged on lattice points (S_{1.1}...) are used as storage gates and are respectively connected by a control gate (C_{1.1},...,C'_{1.1}...).

9. A circuit as claimed in any one of the preceding claims characterised in that the connection between respective control circuit (D) and respective device or the connections within respective control circuits are selectively attained by the wiring process in the circuit fabrication process.

10. A circuit as claimed in any one of Claims 1 to 8 characterised in that the connection between the respective control circuit (D) and respective device or the connections within the respective control circuits is achieved by programmable semi-conductor devices and a circuit comprising a means for selecting the function and determining the arrangement of functions electrically after the circuit is completed.

11. A circuit as claimed in any one of the preceding claims characterised in that there is provided an input/output means for a charge signal such as a charge signal input gate or output gate on the same chip.

12. A circuit as claimed in Claim 4, characterised in that the circuit is further adapted so that a plurality of different operation functions are sequentially performed on overlapping areas on the circuit and the Nth operation output is used as N+1th operation input.

13. A circuit as claimed in Claim 7 characterised in that the output of the digital signal processing circuit is used as control signal for charge transfer.

14. A circuit as claimed in any one of the preceding claims characterised in that the circuit comprises a charge mode floating-point A/D converter including a comparator means for comparing the magnitude of input charge signal and reference charge signal before conversion and wherein the input charge signal is continuously reduced to the half until it will be less than the reference charge signal if the input charge signal is superior to the reference charge signal, the number of times of such reduction to the half is counted additionally as exponent part and thereafter the conversion is executed for computing the mantissa.

15. A circuit as claimed in Claim 14 characterised in that the circuit comprises a reiterative divider whereby a reference charge signal is continuously reduced to the half until it will be less than twice the input charge signal if the input charge signal is inferior to the reference charge signal, the number of times of such reduction to the half is counted subtractionally as exponent part and thereafter the conversion is executed for computing the mantissa.

16. A circuit as claimed in any one of the preceding claims characterised in that the circuit comprises a 2^{N} equal divider of charge signal, comprising a device for dividing a charge signal into two (2) equal parts and an analog signal stack or analog memory means for accumulating (N-1) output signal packets of the one part sequentially, wherein the intermediate results of division into two equal parts added a plurality of times to the initially input charge signal for dividing a charge signal into two parts are stored temporarily in the said analog signal stack or analog memory means for dividing 2^{N} substantially equal charge signal packets.

## Patentansprüche

1. Mehrzweck-Analogverarbeitungsschaltung, welche eine zweidimensionale Gitterform-Schaltung aufweist, die Ladungsverschiebe-Bauelemente (S_{1.1}, ..., C_{1.1},..., C'_{1.1},...) beinhaltet,
**dadurch gekennzeichnet**, daß
ein Potential von allen oder einem Teil von Ladungsverschiebe-Elektroden (S_{1.1},...,C_{1.1},...,C'_{1.1},...) zum Antrieb der Ladungsverschiebe-Bauelemente unabhängig voneinander gesteuert wird, daß Addition, Multiplikation, Division, Verzögerung, Vorzeichenumkehrung und andere arithmetische Operationsfunktionen durch kooperative Steuerung einer Vielzahl von benachbarten Ladungsverschiebe-Bauelementen ((A) ... ) in der zweidimensionalen Gitterform-Schaltung durchgeführt werden, daß mindestens ein analoges Ladungssignal in die zweidimensionale Gitterform-Schaltung eingegeben wird, und zwar vor dem Beginn von jeder arithmetischen Operationsfunktion, und daß eine Antriebssteuerschaltung (D) zur Zufuhr einer Vielzahl von Ladungsverschiebe-Steuersignalen vorgesehen ist, welche einen Steuermodus der zweidimensionalen Gitterform-Schaltung zu den Ladungsverschiebe-Elektroden in der zweidimensionalen Gitterform-Schaltung definieren, wodurch die Vielzahl der Ladungsverschiebe-Bauelemente derart gesteuert werden, daß sie abhängig von dem Steuermodus selektiv eine der arithmetischen Operationsfunktionen durchführen.

2. Schaltung nach Anspruch 1,
**dadurch gekennzeichnet**, daß
eine zweidimensionale Gitterform-Schaltung vorgesehen ist, welche ein quadratisches Gitter verwendet, wobei die Schaltung aus einer Vielzahl von Speichergates (S_{1.1}, ...), von denen jedes ein Ladungsverschiebe-Bauelement ist, welches an jedem Gitterpunkt des quadratischen Gitters angeordnet ist, und aus einer Vielzahl von Ladungsverschiebe-Bauelementen (C_{1.1}..., C'_{1.1}...) aufgebaut ist, von denen jedes mit zwei benachbarten Speichergates entlang des Gitters verbunden ist.

3. Schaltung nach Anspruch 1 oder 2,
**dadurch gekennzeichnet**, daß
die Antriebssteuerschaltung (D) an einer Stelle außerhalb oder innerhalb der Gitterform-Schaltung angeordnet ist.

4. Schaltung nach einem der vorhergehenden Ansprüche,
**dadurch gekennzeichnet**, daß
die Mehrzweck-Analogverarbeitungsschaltung eine Operationsfunktion und ihre Zuordnung auf der Gitterform-Schaltung gemäß dem Steuermodus modifiziert, und zwar wenigstens innerhalb eines bestimmten Bereiches auf der Gitterform-Schaltung.

5. Schaltung nach einem der vorhergehenden Ansprüche,
**dadurch gekennzeichnet**, daß
eine Einrichtung zum Messen der Höhe des Ladungssignals vorgesehen ist, welche unter Bezugnahme auf wenigstens einen Teil der Ladungsverschiebe-Bauelemente gehalten wird.

6. Schaltung nach einem der vorhergehenden Ansprüche,
**dadurch gekennzeichnet**, daß
eine Momentan- und Halteschaltung zur Speicherung des Meßergebnisses der Meßeinrichtung als ein Spannungssignal sowie eine Vergleichereinrichtung zum Vergleichen der Höhe des Spannungssignals vorgesehen sind.

7. Schaltung nach Anspruch 6,
**dadurch gekennzeichnet**, daß
auf demselben Chip eine digitale Signalverarbeitungs-Schaltung zur Durchführung von digitalen Operationsfunktionen unter Verwendung von Ausgabe. signalen der Vergleichereinrichtung als ein Teil der Eingabe vorgesehen ist.

8. Schaltung nach einem der vorhergehenden Ansprüche,
**dadurch gekennzeichnet**, daß
auf Gitterpunkten (S_{1.1} ...) angeordnete Ladungsverschiebe-Bauelemente als Speichergates verwendet werden und jeweils durch ein Steuergate (C_{1.1}, ..., C'_{1.1} ...) verbunden sind.

9. Schaltung nach einem der vorhergehenden Ansprüche,
**dadurch gekennzeichnet**, daß
die Verbindung zwischen der jeweiligen Steuerschaltung (D) und dem zugehörigen Bauelement oder die Verbindungen innerhalb der jeweiligen Steuerschaltungen durch den Verdrahtungsprozeß bei dem Fertigungsprozeß der Schaltung selektiv erreicht werden.

10. Schaltung nach einem der Ansprüche 1 bis 8,
**dadurch gekennzeichnet**, daß
die Verbindung zwischen der jeweiligen Steuerschaltung (D) und des zugehörigen Bauelements oder die Verbindungen innerhalb der jeweiligen Steuerschaltungen durch programmierbare Halbleiter-Bauelemente und eine Schaltung erreicht wird, welche eine Einrichtung zum Auswählen der Funktionen und Bestimmen der Anordnung von Funktionen beinhaltet, und zwar auf elektrische Art und Weise, nachdem die Schaltung vollständig ist.

11. Schaltung nach einem der vorhergehenden Ansprüche,
**dadurch gekennzeichnet**, daß
eine Eingabe/Ausgabe-Einrichtung für ein Ladungssignal vorgesehen ist, wie ein Ladungssignal-Eingabegate oder Ausgabegate auf demselben Chip.

12. Schaltung nach Anspruch 4,
**dadurch gekennzeichnet**, daß
die Schaltung außerdem so angepaßt ist, daß eine Vielzahl von verschiedenen Operationsfunktionen nacheinander auf einander überlappenden Bereichen auf der Schaltung durchgeführt werden und die N-te Operationsausgabe als die N+1-te Operationseingabe verwendet wird.

13. Schaltung nach Anspruch 7,
**dadurch gekennzeichnet**, daß
die Ausgabe der digitalen Signalverarbeitungsschaltung als Steuersignal für die Ladungsverschiebung verwendet wird.

14. Schaltung nach einem der vorhergehenden Ansprüche,
**dadurch gekennzeichnet**, daß
die Schaltung einen Ladungsmodus-Gleitpunkt-A/D-Konverter aufweist, welcher eine Vergleichereinrichtung zum Vergleichen der Größe des Eingabeladungssignals mit dem Referenzladungssignal vor der Konversion beinhaltet, wobei das Eingabeladungssignal kontinuierlich auf die Hälfte reduziert wird, bis es geringer als das Referenzladungssignal ist, falls das Eingabeladungssignal größer ist als das Referenzladungssignal, wobei die Anzahl einer solchen Reduzierung auf die Hälfte zusätzlich als Exponententeil gezählt wird und danach die Konversion zur Berechnung der Mantisse durchgeführt wird.

15. Schaltung nach Anspruch 14,
**dadurch gekennzeichnet**, daß
die Schaltung einen Wiederholteiler aufweist, durch welchen ein Referenzladungssignal kontinuierlich auf die Hälfte reduziert wird, und zwar so lange, bis es weniger als das Doppelte des Eingabeladungssignals ist, falls das Eingabeladungssignal geringer ist als das Referenzladungssignal, wobei die Anzahl einer solchen Reduktion auf die Hälfte subtraktional als Exponententeil gezählt wird und danach die Konversion zur Berechnung der Mantisse durchgeführt wird.

16. Schaltung nach einem der vorhergehenden Ansprüche,
**dadurch gekennzeichnet**, daß
die Schaltung einen 2^{N}-gleichen Teiler für das Ladungssignal aufweist, welcher eine Einrichtung zum Teilen eines Ladungssignal in zwei (2) gleiche Teile aufweist und ein analoger Signalstapel oder eine analoge Speichereinrichtung zur Anhäufung von (N-1) Ausgangssignalpaketen des einen segmentiellen Teils aufweist, wobei die Zwischenergebnisse der Division in zwei gleiche Teile, welche mehrere Male zu dem ursprünglichen Eingabeladungssignal zum Teilen eines Ladungssignals in zwei Teile addiert wurden, temporär in dem analogen Signalstapel oder der analogen Speichereinrichtung zum Teilen von 2^{N} im wesentlichen gleichen Ladungssignalpaketen gespeichert werden.

## Revendications

1. Circuit universel d'opérations analogiques à transfert de charges comportant un circuit en forme de matrice bi-dimensionnelle incluant des dispositifs à transfert de charges (S_{1,1}, ..., C_{1,1}, ..., C'_{1,1} ...) caractérisé en ce qu'un potentiel de toutes les électrodes à transfert de charges (S_{1,1},...,C_{1,1},...,C'_{1,1},...) ou d'une partie de celles-ci, utilisées pour exciter lesdits dispositifs à transfert de charges est commandé de manière indépendante, en ce que l'addition, la multiplication, la division, le retard, l'inversion de signe et d'autres fonctions d'opération arithmétique sont effectués par une commande coopérative d'une pluralité de dispositifs à transfert de charges adjacents ((A) ... ) dans ledit circuit en forme de matrice bi-dimensionnelle, en ce qu'au moins un signal de charge analogique est entré dans ledit circuit en forme de matrice bidimensionnelle avant le début de chaque fonction d'opération arithmétique, et en ce qu'un circuit de commande d'excitation (D) est fourni pour délivrer une pluralité de signaux de commande de transfert de charges définissant un mode de commande dudit circuit en forme de matrice bi-dimensionnelle aux électrodes de transfert de charges dudit circuit en forme de matrice bi-dimensionnelle de sorte que la pluralité des dispositifs à transfert de charges est commandée pour effectuer de manière sélective une des fonctions d'opération arithmétique en fonction du mode de commande.

2. Circuit selon la revendication 1, caractérisé en ce qu'on a fourni un circuit en forme de matrice bi-dimensionnelle en utilisant une matrice carrée, ledit circuit étant constitué d'une pluralité de portes de mémorisation (S_{1,1}, ...), chacune de celles-ci étant un dispositif à transfert de charges agencé en chaque point matriciel de la matrice carrée, et d'une pluralité de dispositifs à transfert de charges (C_{1,1}, ..., C'_{1,1}, ...), chacun de ceux-ci étant reliés à deux portes de mémorisation adjacentes le long de la matrice.

3. Circuit selon la revendication 1 ou la revendication 2, caractérisé en ce que le circuit de commande d'excitation (D) est réparti sur un emplacement situé à l'extérieur ou à l'intérieur dudit circuit en forme de matrice.

4. Circuit selon l'une quelconque des revendications précédentes, caractérisé en ce que ledit circuit universel d'opérations analogiques à transfert de charges modifie une fonction d'opération et son affectation sur ledit circuit en forme de matrice conformément au mode de commande, au moins à l'intérieur d'une certaine zone sur ledit circuit en forme de matrice.

5. Circuit selon l'une quelconque des revendications précédentes, caractérisé en ce qu'on a fourni des moyens pour mesurer le niveau du signal de charge maintenu en fonction d'au moins une partie des dispositifs à transfert de charges.

6. Circuit selon l'une quelconque des revendications précédentes, caractérisé en ce qu'on a fourni un circuit d'échantillonnage et de maintien est prévu pour mémoriser le résultat de mesure des moyens de mesure en tant que signal de voltage et des moyens comparateurs pour comparer l'amplitude dudit signal de voltage.

7. Circuit selon la revendication 6, caractérisé en ce qu'on a fourni sur la même puce un circuit de traitement de signaux numériques pour effectuer des fonctions d'opération numérique en utilisant des signaux de sortie des moyens comparateurs en tant qu'une partie d'entrée.

8. Circuit selon l'une quelconque des revendications précédentes, caractérisé en ce que des dispositifs à transfert de charges agencés sur les points matriciels (S_{1,1}, ...) sont utilisés en tant que portes de mémorisation et sont respectivement reliés par une porte de commande (C_{1,1}, ...C'_{1,1}, ...).

9. Circuit selon l'une quelconque des revendications précédentes, caractérisé en ce que la connexion entre le circuit de commande respectif (D) et le dispositif respectif ou les connexions situées à l'intérieur des circuits de commande respectifs sont réalisées de manière sélective par le procédé de câblage lors du procédé de fabrication du circuit.

10. Circuit selon l'une quelconque des revendications 1 à 8, caractérisé en ce que la connexion entre le circuit de commande respectif (D) et le dispositif respectif ou les connexions situées à l'intérieur des circuits de commande respectifs sont réalisées par des dispositifs à semi-conducteurs programmables et un circuit comportant des moyens pour sélectionner la fonction et déterminer l'agencement des fonctions de manière électrique après l'achèvement du circuit.

11. Circuit selon l'une quelconque des revendications précédentes, caractérisé en ce qu'on a fourni des moyens d'entrée/sortie pour un signal de charge sous forme d'une porte d'entrée ou d'une porte de sortie de signal de charge sur la même puce.

12. Circuit selon la revendication 4, caractérisé en ce que le circuit est de plus adapté de sorte qu'une pluralité de différentes fonctions d'opération sont séquentiellement effectuées sur des zones superposées du circuit et la sortie de la N-ième opération est utilisée en tant qu'entrée de la N + 1-ième l'opération.

13. Circuit selon la revendication 7, caractérisé en ce que la sortie du circuit de traitement de signaux numériques est utilisée en tant que signal de commande pour un transfert de charge.

14. Circuit selon l'une quelconque des revendications précédentes, caractérisé en ce que le circuit comporte un convertisseur A/D en virgule flottante à transfert de charges incluant des moyens comparateurs pour comparer l'amplitude du signal de charge d'entrée et le signal de charge de référence avant la conversion et dans lequel le signal de charge d'entrée est continuellement réduit de moitié jusqu'à ce qu'il soit inférieur au signal de charge de référence, si le signal de charge d'entrée est supérieur au signal de charge de référence, le nombre de réduction de moitié est compté de manière par addition en tant qu'exposant et, par la suite, la conversion est exécutée pour calculer la mantisse.

15. Circuit selon la revendication 14, caractérisé en ce que le circuit comporte un diviseur réitératif de sorte qu'un signal de charge de référence est continuellement réduit de moitié jusqu'à ce qu'il soit inférieur au double du signal de charge d'entrée si le signal de charge d'entrée est inférieur au signal de charge de référence, le nombre de réduction de moitié est compté par soustraction en tant qu'exposant et, par la suite, la conversion est exécutée pour calculer la mantisse.

16. Circuit selon l'une quelconque des revendications précédentes, caractérisé en ce que le circuit comporte un diviseur par 2^{N} de signal de charge, comportant un dispositif pour diviser un signal de charge en deux (2) parties égales et une pile de signaux analogiques ou des moyens de mémorisation analogiques pour accumuler séquentiellement (N - 1) paquets de signaux de sortie de la première partie, dans lequel les résultats intermédiaires de la division en deux parties égales ajoutés une pluralité de fois au signal de charge entré initialement pour diviser un signal de charge en deux parties sont mémorisés temporairement dans ladite pile de signaux analogiques ou dans les moyens de mémorisation analogiques pour une division 2^{N} paquets de signaux de charge pratiquement égaux.
